# EUROPÄISCHE PATENTSCHRIFT

(11) **EP 3 864 420 B1**
(45) Veröffentlichungstag und Bekanntmachung des Hinweises auf die Patenterteilung: **26.10.2022**
(21) Anmeldenummer: 20816387.3
(22) Anmeldetag: 23.09.2020
(51) Int. Cl.: G01R 15/18, G01R 22/10

(54) **VERFAHREN ZUR MESSUNG VON ELEKTRISCHEN STRÖMEN UND SPANNUNGEN SOWIE ENERGIEZÄHLER**
METHOD FOR MEASURING ELECTRICAL CURRENTS AND VOLTAGES, AND ENERGY METER
PROCÉDÉ DE MESURE DE COURANTS ET DE TENSIONS ÉLECTRIQUES, ET COMPTEUR D'ÉNERGIE

(30) Priorität: 07.11.2019 DE 102019129992
(43) Veröffentlichungstag der Anmeldung: 18.08.2021
(73) Patentinhaber: Bürger, Roland, 21244 Buchholz (DE)
(72) Erfinder: Peter, Mathias, 21244 Buchholz (DE)
(74) Vertreter: Klickow & Wetzel PartGmbB
(86) Internationale Anmeldenummer: PCT/DE2020/100820
(87) Internationale Veröffentlichungsnummer: WO 2021/089077

(56) Entgegenhaltungen:
- EP-A1- 2 787 357
- US-A1- 2003 088 374
- US-A1- 2003 151 415
- US-A1- 2012 221 278
- US-A1- 2015 137 596

## Beschreibung

Die Erfindung betrifft ein Verfahren zur Messung von elektrischen Strömen, wobei ein elektrischer Strom mithilfe eines induktiven Stromwandlers in Betrag und Phase gemessen wird.

Darüber hinaus betrifft die Erfindung ein Verfahren zur Messung von elektrischen Spannungen, wobei eine elektrische Spannung mithilfe eines induktiven Spannungswandlers in Betrag und Phase gemessen wird.

Darüber hinaus betrifft die Erfindung einen Energiezähler, mit dem die Leistungsaufnahme eines Verbrauchers oder einer Vielzahl von Verbrauchern über eine Zeitspanne messbar ist.

Derartige Verfahren zur Messung von elektrischen Strömen oder Spannungen finden beispielsweise im Bereich von Energiezählern zur Ermittlung des Energieverbrauches von Unternehmen oder Haushalten Verwendung. Nachfolgend umfasst der Begriff des Energiezählers immer auch Ausführungsvarianten anderer elektrischer Messeinrichtungen zur Durchführung von Strom- und/oder Spannungsmessungen, beispielsweise von Schutzrelais.

Stand der Technik findet sich beispielsweise in den Dokumenten US2003/088374 und US2012/221278.

Häufig werden bei der Messung des elektrischen Stromes dabei Stromwandler genutzt, mit denen ein betragsmäßig großer Primärstrom in einen betragsmäßig kleineren Sekundärstrom gewandelt wird, sodass einfachere und kostengünstigere Messmittel verwendbar sind. Physikalisch betrachtet sind die hier betrachteten Stromwandler dabei Transformatoren, die im Beinahe-Kurzschlussbereich betrieben werden. Es handelt sich somit um induktive Messwandler, deren Aufgabe es ist, Ströme proportional und phasentreu zu übertragen, sodass diese für Messgeräte auf niedrigem Potential erfassbar sind.

Insbesondere im Anwendungsfall für einen Energiezähler ist die Messgenauigkeit des Messsystems von erheblicher Bedeutung. Einen entscheidenden Einfluss auf die Messgenauigkeit des Energiezählers hat dabei der Stromwandler. Die Auswahl geeigneter Stromwandler erfolgt dabei nach dem aktuellen Stand der Technik gemäß in der Norm IEC 61869-1/2 festgelegter Klassen, für die bestimmte Klassengenauigkeiten vorgegeben sind. Vorgegeben sind für die Klassen dabei die maximalen Abweichungen in Betrag und Phase in Abhängigkeit des anliegenden Stromes in Prozent des Bemessungsstromes. Die Abweichung ist dabei und auch im Sinne dieser Schrift definiert als die Abweichung des tatsächlich messbaren Sekundärstromes im Vergleich mit dem idealen Sekundärstrom des Messsystems, der ohne weitere Abweichung in Betrag und ohne Phasenverschiebung dem gemäß des Windungszahlverhältnisses des Stromwandlers aus dem durch einen Primärleiter fließenden Primärstrom übersetzten Sekundärstrom entspricht.

Eine gängige Messmethode zur Ermittlung der Genauigkeit eines Stromwandlers ist dabei neben der Primärmethode die Sekundärspannungsmethode. Die Sekundärspannungsmethode, die auch als modellbasiertes Messverfahren bezeichnet wird, beruht auf Messungen, die von der Sekundärseite des Stromwandlers her durchgeführt werden. Die Sekundärspannungsmethode ist inzwischen in der Norm IEC 61869-2 als alternative Messung angeführt. Aus mehreren Messungen nach der Sekundärspannungsmethode lassen sich die Werte der Komponenten eines Ersatzschaltbildes des Stromwandlers bestimmen und so ein mathematisches Modell des Stromwandlers generieren.

Reale Stromwandler weisen Eisenverluste im Kern des Transformators und Verluste in den Kupferwicklungen auf, die zu einer Abweichung der Sekundärgröße im Vergleich mit einem idealen Stromwandler führen.

Zur Erreichung der vorgegebenen Klassengenauigkeiten für hochgenaue Stromwandler werden die Stromwandler durch die Auswahl und Auslegung der verwendeten Materialien, insbesondere des Kernmaterials des Transformators und den Querschnitt der Kupferleitungen, optimiert. Dazu werden beispielsweise verlustarme Eisenmaterialien, wie Nickeleisen, eingesetzt und die Querschnitte der Kupferleitungen der Wicklungen und/oder der Querschnitt des Kerns erhöht, wodurch die Kosten für derartige hochgenaue Stromwandler signifikant erhöht werden.

Darüber hinaus ist das Übertragungsverhalten der Stromwandler über den Messbereich nicht linear, sodass insbesondere im Fall von kleinen oder sehr großen Primärströmen erhebliche Abweichungen im Messergebnis auftreten.

Ein möglicher Korrekturfaktor, wie beispielsweise in der internationalen Norm für Stromsensoren festgelegt, wird nicht vorgeschlagen oder definiert. Dies liegt daran, dass Stromwandler sich gerade nicht linear von 0 A bis zum angegebenen Bemessungsstrom verhalten. Ebenfalls sind die Fehlerwerte sehr stark von der Belastungsbürde, die in der Regel durch die Eingangsimpedanz des Messgerätes und den Widerstand der Zuleitung gegeben ist, des Stromwandlers abhängig. Diese variiert von Messgerät zu Messgerät. Auch die Impedanz der Zuleitung, die vornehmlich von der Länge und dem Querschnitt der Leitung abhängt, variiert von Anlage zu Anlage. Aus diesen Gründen ist der Einsatz eines einzelnen Korrekturfaktors zur Kompensation der vom Stromwandler bedingten Messfehler im Messgerät nicht praktikabel. Die Abhängigkeit der Fehlerwerte von der Belastungsbürde bedeutet auch eine Besonderheit von induktiven Stromwandlern mit einem zu messenden Stromsignal als Ausgangssignal gegenüber induktiven Spannungswandlern mit einem zu messenden Spannungssignal als Ausgangssignal. Denn für Strom- oder Spannungssensoren mit einem zu messenden Spannungssignal als Ausgangssignal gelten zu Begrenzung des Messfehlers lediglich Anforderungen für eine Mindestimpedanz des Messeingangs (beispielsweise 20 kOhm bei Stromsensoren und 200 kOhm bei Spannungssensoren) ab der das Sekundärsignal der Sensoren nicht mehr beeinflusst wird, sodass die Erfassung von Korrekturfaktoren für derartige Sensoren wesentlich einfacher ist. Auch die von den Herstellern entsprechender induktiver Messwandler nach normativen Vorgaben geprüften Genauigkeiten der Messwandler bei vorgegebenen Bürden (beispielsweise bei 25 % und bei 100% der Nennbürde) erlauben keinen unmittelbaren Rückschluss auf die Fehlerwerte bei abweichenden Bürden.

Eine Aufgabe der Erfindung ist es, ein Verfahren zur Messung von elektrischen Strömen anzugeben, das eine verbesserte Messgenauigkeit über einen weiten Wertebereich des Primärstroms ermöglicht.

Diese Aufgabe wird erfindungsgemäß durch ein Verfahren zur Messung von elektrischen Strömen aufweisend die Merkmale des Patentanspruchs 1 gelöst.

Eine weitere Aufgabe der Erfindung ist es, ein Verfahren zur Messung von elektrischen Spannungen anzugeben, das eine verbesserte Messgenauigkeit über einen weiten Wertebereich der Primärspannung ermöglicht.

Diese Aufgabe wird erfindungsgemäß durch ein Verfahren zur Messung von elektrischen Spannungen aufweisend die Merkmale des Patentanspruchs 9 gelöst.

Eine weitere Aufgabe der Erfindung ist es, einen Energiezähler anzugeben, mit dem eine genaue Messung des Stromes auch für weniger genaue Stromwandler ermöglicht ist.

Diese Aufgabe wird erfindungsgemäß durch einen Energiezähler aufweisend die Merkmale des Patentanspruchs 15 gelöst.

Die nachfolgend offenbarten Merkmale eines Verfahrens zur Messung von elektrischen Strömen sind sowohl einzeln als auch in allen ausführbaren Kombinationen Bestandteil der Erfindung.

Ein erfindungsgemäßes Verfahren zur Messung von elektrischen Strömen verwendet mindestens einen induktiven Stromwandler zur Bestimmung mindestens eines durch mindestens einen Primärleiter fließenden elektrischen Stroms, wobei der mindestens eine Stromwandler eine Primärseite und eine galvanisch von der Primärseite getrennte Sekundärseite aufweist. Mithilfe einer Messvorrichtung wird der sekundärseitige Strom gemessen.

Das erfindungsgemäße Verfahren zur Messung elektrischer Ströme verwendet ein Messsystem, das mindestens einen Stromwandler, eine Messvorrichtung und eine Verbindungsleitung zwischen der Sekundärseite des Stromwandlers und einem Strommesseingang der Messvorrichtung aufweist, wobei mit dem Messsystem der durch mindestens einen Primärleiter fließende Strom bestimmbar ist.

Die vom elektrischen Aufbau des realen Messsystems verursachten Abweichungen des sekundärseitigen Stromes in Betrag und Phase im Vergleich mit einem idealen System werden in einem erfindungsgemäßen Verfahren zur Messung von elektrischen Strömen unter Verwendung eines mathematischen Modells zumindest des Stromwandlers kompensiert.

Das mathematische Modell eines Stromwandlers ist dabei durch ein elektrisches Ersatzschaltbild des Stromwandlers und die Werte der elektrischen Bauelemente des Ersatzschaltbildes gegeben.

In einer bevorzugten Ausführungsform der Erfindung wird ein im Hinblick auf die Verschaltung der elektrischen Bauelemente und deren Werte möglichst genaues elektrisches Ersatzschaltbild des Stromwandlers verwendet.

In dem erfindungsgemäßen Verfahren zur Messung elektrischer Ströme wird das elektrische Ersatzschaltbild bzw. das Modell des Stromwandlers verwendet, um die Abweichung des Messstromes vom idealen Sekundärstrom in Betrag und Phase in Abhängigkeit des gemessenen Stromes zu bestimmen.

In dem erfindungsgemäßen Verfahren berücksichtigt das Modell des Stromwandlers weiterhin die tatsächliche Bebürdung des Stromwandlers im Sinne der Eingangsimpedanz der Messvorrichtung und/oder des Leitungswiderstands der Leitung vom Stromwandler zur Messvorrichtung.

Dazu weist das mathematische Modell des Stromwandlers zusätzliche Werte für die Eingangsimpedanz der Messvorrichtung und/oder den Leitungswiderstand der Leitung vom Stromwandler zur Messvorrichtung auf.

In einer Ausführungsform eines erfindungsgemäßen Verfahrens ist das Modell des Stromwandlers in einer auslesbaren digitalen Datei gespeichert.

In einer Ausführungsform eines erfindungsgemäßen Verfahrens ist das Modell des Stromwandlers in einer XML-Datei, in einer XLS-Datei, in einer CSV-Datei oder in einem vergleichbaren Dateiformat gespeichert.

In einer bevorzugten Ausführungsform des erfindungsgemäßen Verfahrens zur Messung elektrischer Ströme ist dieses als ein Verfahren zur Kompensation mindestens eines Stromwandlers für einen Energiezähler ausgebildet.

In einer Ausführungsform der Erfindung ist ein solches Messsystem bzw. ein erfindungsgemäßes Verfahren zur Messung elektrischer Ströme zur Messung der Primärstrome von 1 bis 3 Phasen, d.h. der Ströme auf 1 bis 3 Primärleitungen, ausgelegt, wobei für jede Phase ein Stromwandler vorgesehen ist. Jedoch ist die Messung in Ausführungsformen der Erfindung auch für mehr als drei Phasen möglich.

In einer Ausführungsform der Erfindung wird das Modell des mindestens einen in einem Messsystem verwendeten Stromwandlers in einem Verfahrensschritt mithilfe einer Übertragungsvorrichtung an die Messvorrichtung des Messsystems übertragen.

In einer Ausführungsform der Erfindung ist das Modell des Stromwandlers für eine definierte Betriebstemperatur in einer Speichervorrichtung der Messvorrichtung hinterlegt und abrufbar.

In einer Ausführungsform der Erfindung liegt die Betriebstemperatur, für die das Modell des Stromwandlers hinterlegt ist, bei etwa 20°C.

In einer weiteren Ausführungsform der Erfindung ist das Modell des Stromwandlers für mehrere definierte Betriebstemperaturen in einer Speichervorrichtung der Messvorrichtung hinterlegt und abrufbar, sodass auch temperaturabhängige Fehlereinflüsse kompensierbar sind.

In einer Ausführungsform eines erfindungsgemäßen Verfahrens zur Messung elektrischer Ströme wird bei der Montage des Messsystems der Typ des verwendeten Stromwandlers mithilfe einer Übertragungsvorrichtung ausgelesen. Dazu weisen die Stromwandler eines Typs eine eindeutige Kodierung auf. Diese Kodierung kann beispielsweise die Seriennummer sein, die zusätzlich in Form eines Barcodes oder eines QR-Codes auf das Gehäuse des Stromwandlers aufgedruckt sein kann. Diese Kodierung wird in einem Verfahrensschritt mithilfe der Übertragungsvorrichtung ausgelesen oder in diese eingegeben.

Weiterhin kann die Kodierung eines Stromwandlers auch eine Herstellerkennung enthalten.

Mithilfe des Übertragungsgerätes wird in einer Ausführungsform des erfindungsgemäßen Verfahrens das mathematische Modell des jeweiligen Stromwandlers anhand der Kodierung aus einer auf einem Server bzw. Webserver hinterlegten Datenbank über eine geeignete Schnittstelle abgerufen.

In einer besonders bevorzugten Ausführungsform der Erfindung beinhaltet die auf dem Gehäuse des Stromwandlers aufgedruckte Kodierung neben der Seriennummer oder einem entsprechenden Identifikationskode, zusätzlich oder ausschließlich einen Link zum Download des Modells des Stromwandlers aus dem Internet.

Das mithilfe der Übertragungsvorrichtung abgerufene mathematische Modell des Stromwandlers wird in einer Ausführungsform des erfindungsgemäßen Verfahrens über eine geeignete Schnittstelle an die Messvorrichtung übertragen.

In einer Ausführungsform des erfindungsgemäßen Verfahrens wird das mathematische Modell des Stromwandlers mithilfe der Übertragungsvorrichtung um Daten bezüglich der Leitungsimpedanz der Leitung zwischen Stromwandler und Messvorrichtung und/oder die Eingangsimpedanz der Messvorrichtung ergänzt.

Die Übertragungsvorrichtung ist in einer Ausführungsform als ein Smartphone, ein Tablet oder als ein PC mit geeigneter auf der Übertragungsvorrichtung installierter Software ausgebildet.

In einer weiteren Ausführungsform des erfindungsgemäßen Verfahrens wird das mathematische Modell des Stromwandlers direkt an der Messvorrichtung um Daten bezüglich der Leitungsimpedanz der Leitung zwischen Stromwandler und Messvorrichtung und/oder die Eingangsimpedanz der Messvorrichtung ergänzt.

Beispielsweise weist die Messvorrichtung dazu geeignete Eingabemittel auf, die für das erfindungsgemäße Verfahren in der entsprechenden Ausführungsform genutzt werden.

In einer anderen Ausführungsform der Erfindung wird das mathematische Modell des Stromwandlers auf der Messvorrichtung automatisch zumindest um die Eingangsimpedanz der Messvorrichtung ergänzt.

In einer weiteren Ausführungsform der Erfindung weist das mathematische Modell des Stromwandlers bereits vor der Übertragung an die Messvorrichtung Werte für die Leitungsimpedanz der Leitung zwischen Stromwandler und Messvorrichtung und/oder die Eingangsimpedanz der Messvorrichtung auf.

In einer Ausführungsform der Erfindung sind dazu Standardwerte im mathematischen Modell des Stromwandlers hinterlegt.

In einer bevorzugten Ausführungsform der Erfindung ist zumindest die Eingangsimpedanz der Messvorrichtung anhand der tatsächlich verwendeten Messvorrichtung vorgegeben, beispielsweise, indem diese anhand der Seriennummer der Messvorrichtung bzw. des Energiezählers oder der Auswahl der verwendeten Messvorrichtung bzw. des verwendeten Energiezählers aus einer vorgegebenen Liste automatisch ausgewählt wird. Darüber hinaus ist auch die Übermittlung einer gemessenen Eingangsimpedanz der Messvorrichtung und die Ergänzung des mathematischen Modells durch diesen übertragenen Wert möglich.

Die Ergänzung der Leitungsimpedanz der Leitung zwischen Stromwandler und Messvorrichtung kann durch Übertragung einer gemessenen Leitungsimpedanz, durch die Auswahl aus einer vorgegebenen Liste oder durch den aus einer Eingabe der Leitungslänge und des Querschnitts automatisch berechneten Wert erfolgen.

Die Ergänzung des mathematischen Modells des Stromwandlers um die Leitungsimpedanz der Leitung zwischen Stromwandler und Messvorrichtung und/oder die Eingangsimpedanz der Messvorrichtung kann an dem Speicherort des mathematischen Modells des Stromwandlers, von dem dieses abrufbar ist, oder auf der Übertragungsvorrichtung implementiert sein.

In der Messvorrichtung wird in Ausführungsformen der Erfindung das mathematische Modell des Stromwandlers und ggf. der Eingangsimpedanz der Messvorrichtung und/oder der Leitungsimpedanz der Leitung zwischen Stromwandler und Messvorrichtung in einer Speichervorrichtung gespeichert.

Wird mithilfe des Messsystems eine Strommessung durchgeführt, wird in einer Ausführungsform des erfindungsgemäßen Verfahrens das mathematische Modell des mindestens einen Stromwandlers zur Messung von elektrischen Strömen aus der Speichervorrichtung geladen und die Messabweichung des mindestens einen gemessenen Stroms vom Sekundärstrom des idealen Messsystems mithilfe des mathematischen Modells kompensiert.

In einer weiteren Ausführungsform eines erfindungsgemäßen Verfahrens zur Messung von elektrischen Strömen wird das bevorzugt um die Daten der jeweiligen Zuleitung und der Eingangsimpedanz der Messvorrichtung ergänzte mathematische Modell des mindestens einen Stromwandlers verwendet, um daraus eine Kompensationstabelle zu berechnen. Dabei kann sowohl zunächst die gesamte Kompensationstabelle oder nur Teile der Kompensationstabelle erzeugt werden.

In einer Ausführungsform eines erfindungsgemäßen Verfahrens wird die Kompensationstabelle mithilfe der Übertragungsvorrichtung erzeugt und nur die Kompensationstabelle wird ohne mathematisches Modell des Stromwandlers auf die Messvorrichtung übertragen.

Die in Ausführungsformen der Erfindung verwendete Kompensationstabelle gibt für einen auf der Sekundärseite des jeweiligen Stromwandlers gemessenen Sekundärstrom in Abhängigkeit einer zuvor festgelegten Bemessungsleistung des Stromwandlers auf der Basis des mathematischen Modells des Stromwandlers, bevorzugt ergänzt um die Daten der Zuleitungs- und/oder der Eingangsimpedanz der Messvorrichtung, den Betrag und/oder die Phase des idealen sekundärseitigen Stromes an, sodass von diesem unter Verwendung des Windungszahlverhältnisses des Stromwandlers auf den tatsächlichen primärseitigen Strom geschlossen werden kann. Die festgelegte Bemessungsleistung wird dabei durch den Widerstand der Zuleitung und das Messgerät ermittelt.

In einer weiteren Ausführungsform eines erfindungsgemäßen Verfahrens zur Messung von elektrischen Strömen gibt die Kompensationstabelle für einen auf der Sekundärseite des jeweiligen Stromwandlers gemessenen Sekundärstrom in Abhängigkeit einer zuvor festgelegten Bemessungsleistung des Stromwandlers auf der Basis des mathematischen Modells des Stromwandlers, bevorzugt ergänzt um die Daten der Zuleitungs- und der Eingangsimpedanz der Messvorrichtung, direkt den tatsächlichen Betrag und/oder die tatsächliche Phase des primärseitigen Stromes an.

In einer Ausführungsform der Erfindung wird anstatt der diskreten Werte des gemessenen Sekundärstroms der jeweilige Effektivwert des gemessenen Sekundärstromes zur Kompensation und Berechnung des Primärstromes verwendet.

Da die Fehlerwerte in der Kompensationstabelle in einer bevorzugten Ausführungsform des Verfahrens ebenfalls als Effektivwerte angegeben werden, können dann die aus den Messungen abgeleiteten Effektivwerte korrigiert werden.

In einer alternativen Ausführungsform werden hingegen die einzelnen Abtastwerte des Sekundärstromes, beispielsweise in dem entsprechenden für die Effektivwertberechnung herangezogenen Zeitintervall, einzeln korrigiert.

Zur Berechnung der Leistungsaufnahme mindestes eines an der mindestens einen Primärleitung angeschlossenen Verbrauchers werden in einer Ausführungsform der Erfindung für eine 50 Hz-Schwingung die Effektivwerte von Strom und Spannung multipliziert. In einer anderen Ausführungsform des Verfahrens werden die diskreten Werte von Strom und Spannung zu den Abtastzeitpunkten einzeln multipliziert.

Ein erfindungsgemäßes Verfahren zur Messung elektrischer Ströme ermöglicht durch die vorstehend offenbarten Merkmale die Verwendung kostengünstiger Stromwandler, da die Kompensation auch größerer Fehler mithilfe des mathematischen Modells des Stromwandlers erfolgt.

Unter der Verwendung eines erfindungsgemäßen Verfahrens zur Messung elektrischer Ströme sind über einen weiten Betriebsbereich hochgenaue Messsysteme realisierbar.

Der Messfehler des erfindungsgemäßen Verfahrens hängt dabei von der Genauigkeit des Modells des Stromwandlers und der ggf. dem Modell hinzugefügten Daten der Zuleitung und/oder der Eingangsimpedanz der Messvorrichtung ab.

Bei einer Anwendung des erfindungsgemäßen Verfahrens zur Messung von elektrischen Strömen in einem Energiezähler findet neben der Strommessung in der Regel auch eine Spannungsmessung statt. Im Falle von Mittel- und Hochspannungsanwendungen wird diese Spannung nicht direkt gemessen, sondern über einen Spannungswandler in einen niedrigeren Spannungsbereich gewandelt. In der Regel werden ab etwa 1000 V Spanungswandler eingesetzt.

In einer bevorzugten Ausführungsform der Erfindung ist das Verfahren zur Messung von elektrischen Strömen in einem Energiezähler daher mit einem analog implementierten Kompensationsverfahren für die mindestens eine zusätzlich zum mindestens einen elektrischen Strom gemessene elektrische Spannung ergänzt.

Dazu wird in einer Ausführungsform der Erfindung ein mathematisches Modell mindestens eines eingesetzten Spannungswandlers auf die Messvorrichtung aufgespielt und bei der Messung mindestens einer elektrischen Spannung direkt oder in Form einer erzeugten Kompensationstabelle zur Kompensation der mindestens einen gemessenen elektrischen Spannung verwendet.

In einer weiteren Ausführungsform des erfindungsgemäßen Verfahrens wird die Kompensationstabelle zur Kompensation der mindestens einen elektrischen Spannung mithilfe der Übertragungsvorrichtung erzeugt und an die Messvorrichtung übertragen.

In einer bevorzugten Ausführungsform eines erfindungsgemäßen Verfahrens wird je Phase mithilfe eines Stromwandlers ein elektrischer Strom und mithilfe eines Spannungswandlers eine elektrische Spannung gemessen und jeweils basierend auf den mathematischen Modellen der eingesetzten Strom- bzw. Spannungswandler, bevorzugt ergänzt um die Daten der jeweiligen Zuleitungen zur Messvorrichtung sowie die Eingangsimpedanzen der Messvorrichtung am Strom- und am Spannungsmesseingang, kompensiert.

Die nachfolgend offenbarten Merkmale eines erfindungsgemäßen Energiezählers sind sowohl einzeln als auch in allen ausführbaren Kombinationen Teil der Erfindung.

Ein erfindungsgemäßer Energiezähler weist mindestens eine Messvorrichtung auf, die zur Messung mindestens eines elektrischen Stromes und mindestens einer elektrischen Spannung je Phase einer Leitung für elektrischen Strom ausgebildet ist.

Erfindungsgemäß weist der Energiezähler eine Speichereinrichtung zur Speicherung des mathematischen Modells mindestens eines mit dem Energiezähler verbundenen Stromwandlers und/oder der zugeordneten Kompensationstabelle und in einer bevorzugten Ausführungsform weiterhin zur Speicherung des mathematischen Modells mindestens eines mit dem Energiezähler verbundenen Spannungswandlers und/oder der zugeordneten Kompensationstabelle auf.

Erfindungsgemäß weist der Energiezähler eine Schnittstelle zur Übertragung der Daten des mindestens einen mathematischen Modells des bzw. der verbundenen Strom- und/oder Spannungswandler und/oder der zugeordneten Kompensationstabellen auf den Energiezähler auf.

In einer Ausführungsform der Erfindung ist der mindestens eine sekundärseitig gemessene Strom mithilfe des Energiezählers in Bezug auf den durch den jeweiligen Stromwandler in Verbindung mit der Impedanz der jeweiligen Zuleitung und der Eingangsimpedanz des jeweiligen Strommesseingangs der Messvorrichtung verursachten Fehler kompensierbar.

In einer bevorzugten Ausführungsform der Erfindung ist darüber hinaus die mindestens eine sekundärseitig gemessene Spannung mithilfe des Energiezählers in Bezug auf den durch den jeweiligen Spannungswandler in Verbindung mit der Impedanz der jeweiligen Zuleitung und der Eingangsimpedanz des jeweiligen Spannungsmesseingangs der Messvorrichtung verursachten Fehler kompensierbar.

Erfindungsgemäß weist der Energiezähler dazu eine Kompensationseinheit auf, mit der die jeweilige Messgröße basierend auf dem mathematischen Modell des jeweiligen Strom- bzw. Spannungswandlers kompensierbar ist.

Erfindungsgemäß ist die jeweilige Messgröße mithilfe einer jeweils zugeordneten Kompensationstabelle durch die Kompensationseinheit des Energiezählers kompensierbar.

In einer Ausführungsform der Erfindung sind die vorstehend offenbarten Merkmale des Verfahrens zur Messung elektrischer Ströme, die vom Erfassen der Kodierung des Strom- und/oder Spannungswandlers bis zum Aufspielen des mathematischen Modells bzw. der mathematischen Modelle des Wandlers oder der Wandler Teil eines eigenständigen Verfahrens zum Aufspielen eines mathematischen Modells eines Stromwandlers auf eine Messvorrichtung. Ein solches erfindungsgemäßes Verfahren zum Aufspielen eines mathematischen Modells eines Stromwandlers auf einen Energiezähler ist dadurch gekennzeichnet, dass in einem Verfahrensschritt mithilfe einer Übertragungsvorrichtung eine typenbezogene Kodierung eines mit einem Energiezähler verbundenen oder mit diesem Energiezähler zu verbindenden Stromwandlers ausgelesen wird, dass in einem weiteren Verfahrensschritt mithilfe der ausgelesenen Kodierung ein mathematisches Modell des jeweiligen Stromwandlers von einem Webserver auf die Übertragungsvorrichtung heruntergeladen wird, dass in einem weiteren Verfahrensschritt das mathematische Modell des jeweiligen Stromwandlers über eine Schnittstelle an den Energiezähler übermittelt wird und dass das mathematische Modell des Stromwandlers in einem weiteren Verfahrensschritt in einer Speichereinrichtung des Energiezählers gespeichert wird.

Bezüglich der Ausprägung der Kodierung des Stromwandlers wird auf die vorstehende Beschreibung des erfindungsgemäßen Verfahrens zur Messung elektrischer Ströme verwiesen.

In einer weiteren Ausführungsform eines erfindungsgemäßen Verfahrens zum Aufspielen eines mathematischen Modells eines Stromwandlers auf einen Energiezähler ist dieses weiterhin dadurch gekennzeichnet, dass das mathematische Modell des Stromwandlers mithilfe der Übertragungsvorrichtung um die Impedanz der Leitung zwischen dem Stromwandler und dem Energiezähler und/oder die Eingangsimpedanz der Messvorrichtung des Energiezählers ergänzbar ist.

In einer weiteren Ausführungsform des erfindungsgemäßen Verfahrens ist das mathematische Modell eines Stromwandlers direkt am Energiezähler um die Impedanz der Zuleitung und/oder der Eingangsimpedanz der Messvorrichtung des Energiezählers ergänzbar.

In einer weiteren Ausführungsform eines erfindungsgemäßen Verfahrens zum Aufspielen eines mathematischen Modells eines Stromwandlers auf einen Energiezähler ist dieses auch dadurch gekennzeichnet, dass das mathematische Modell des Stromwandlers in einer digitalen Datei gespeichert ist.

In einer weiteren Ausführungsform eines erfindungsgemäßen Verfahrens zum Aufspielen eines mathematischen Modells eines Stromwandlers auf einen Energiezähler ist dieses auch dadurch gekennzeichnet, dass die typenbezogene Kodierung des Stromwandlers einen Downloadlink zum Download des mathematischen Modells des Stromwandlers enthält.

Der Download des mathematischen Modells des Stromwandlers erfolgt in einer Ausführungsform eines erfindungsgemäßen Verfahrens zum Aufspielen eines mathematischen Modells eines Stromwandlers auf einen Energiezähler über eine Internetverbindung von einem Webserver.

In einer bevorzugten Ausführungsform eines erfindungsgemäßen Verfahrens zum Aufspielen eines mathematischen Modells eines Stromwandlers auf einen Energiezähler ist das mathematische Modell des Stromwandlers mithilfe der Sekundärspannungsmethode erzeugt.

In einer besonders bevorzugten Ausführungsform ist das erfindungsgemäße Verfahren zum Aufspielen eines mathematischen Modells eines Stromwandlers auf einen Energiezähler um ein analog implementiertes Verfahren zum Aufspielen eines mathematischen Modells eines Spannungswandlers auf einen Energiezähler ergänzt.

In bevorzugten Ausführungsformen eines erfindungsgemäßen Verfahrens zur Messung elektrischer Ströme und eines erfindungsgemäßen Verfahrens zur Messung elektrischer Spannungen wird zunächst die Impedanz der Zuleitung und/oder die Eingangsimpedanz der Messvorrichtung bestimmt und mithilfe der Übertragungsvorrichtung an den Webserver übertragen. In Verbindung mit den ebenfalls mithilfe der Übertragungsvorrichtung an den Webserver übertragenen Daten zur Identifikation des verwendeten Stromwandlers oder Spannungswandlers wird auf dem Webserver das jeweilige mathematische Modell des Stromwandlers oder Spannungswandlers um die Impedanz der Zuleitung und/oder die Eingangsimpedanz der Messvorrichtung ergänzt und eine für die jeweilige Kombination von Stromwandler bzw. Spannungswandler, Messvorrichtung bzw. Energiezähler und ggf. der Leitung zwischen Stromwandler oder Spannungswandler und Messvorrichtung angepasste Kompensationstabelle erzeugt. Diese individuelle Kompensationstabelle wird anschließend vom Webserver an die Übertragungsvorrichtung übermittelt, von der diese über eine Schnittstelle an den Energiezähler übermittelt und in einer Speichereinrichtung des Energiezählers gespeichert wird.

Die Übertragung der erzeugten Kompensationstabelle anstelle des mathematischen Modells auf den Energiezähler ermöglicht die Verwendung von Energiezählern mit einer geringeren Rechenleistung, da die Kompensationstabelle nicht auf diesem erzeugt werden muss.

In weiteren Ausführungsformen des erfindungsgemäßen Verfahrens zur Messung elektrischer Ströme und eines erfindungsgemäßen Verfahrens zur Messung elektrischer Spannungen sind die mathematischen Modelle der Stromwandler oder Spannungswandler nicht auf einem Webserver sondern auf einem lokalen PC oder der Übertragungsvorrichtung selbst gespeichert und werden auf diesem anhand der erfassten Typenbezeichnung des Stromwandlers oder Spannungswandlers ausgewählt.

Sind die mathematischen Modelle auf einem lokalen PC gespeichert so wird die erfasste Typenbezeichnung des Stromwandlers oder Spannungswandlers ggf. in Verbindung mit der Impedanz der Zuleitung und/oder der Eingangsimpedanz der Messvorrichtung von der Übertragungsvorrichtung über eine geeignete Schnittstelle, wie beispielsweise USB, Bluetooth oder WLAN, von der Übertragungsvorrichtung an den PC übermittelt und das entsprechende mathematische Modell oder die entsprechende auf dem PC aus dem mathematischen Modell erzeugte Kompensationstabelle vom PC an die Übertragungsvorrichtung übermittelt.

Sind die mathematischen Modelle auf der Übertragungsvorrichtung gespeichert, so wird auf der Übertragungsvorrichtung selbst anhand der Typenbezeichnung des Stromwandlers oder Spannungswandlers das entsprechende mathematische Modell ausgewählt und in Ausführungsformen des erfindungsgemäßen Verfahrens aus dem ausgewählten mathematischen Modell auf der Übertragungsvorrichtung die entsprechende Kompensationstabelle erzeugt, wobei das mathematische Modell ggf. durch die Impedanz der Zuleitung und/oder der Eingangsimpedanz der Messvorrichtung ergänzt wurde.

In den nachfolgenden Zeichnungen sind beispielhafte Ausführungsformen der erfindungsgemäßen Verfahren und eines Anwendungsbeispiels für einen Energiezähler dargestellt. Es zeigen:
- Figur 1:: Eine schematische Darstellung einer Messvorrichtung, die für ein erfindungsgemäßes Verfahren verwendbar ist,
- Figur 2:: Eine schematische Darstellung des elektrischen Ersatzschaltbildes eines Stromwandlers,
- Figur 3a:: Eine beispielhafte Kompensationstabelle für den sekundärseitig gemessenen Strom in Bezug auf den Betrag des Stromes,
- Figur 3b:: Eine beispielhafte Kompensationstabelle für den sekundärseitig gemessenen Strom in Bezug auf die Phase des Stromes,
- Figur 4:: Eine Darstellung des gemessenen und des kompensierten sekundärseitigen Stromes,
- Figur 5:: Eine schematische Darstellung der messtechnischen Abtastung des sekundärseitigen Stromsignals,
- Figur 6:: Eine schematische Darstellung des elektrischen Ersatzschaltbildes eines Spannungswandlers,
- Figur 7:: Ein Ablaufdiagramm eines erfindungsgemäßen Verfahrens zur Messung elektrischer Ströme und
- Figuren 8a und 8b:: Eine schematische Darstellung des Verfahrens zum Aufspielen eines mathematischen Modells eines Strom- bzw. Spannungswandlers auf einen Energiezähler.

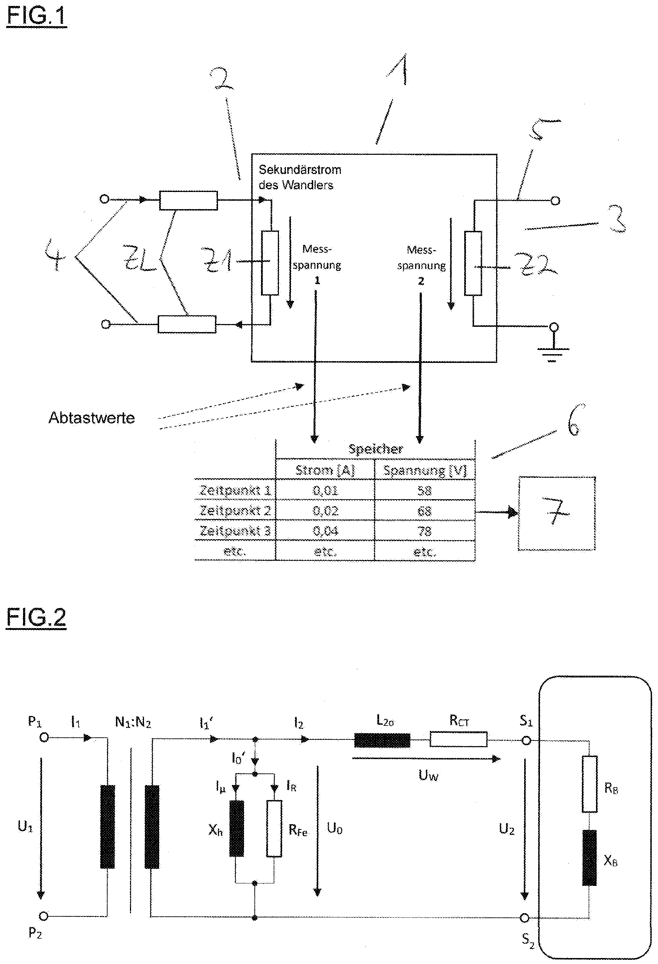

Figur 1 zeigt eine schematische Darstellung des Anwendungsbeispiels für eine Messvorrichtung (1) mit einem Strommesseingang (2) und einen Spannungsmesseingang (3), wie beispielsweise die Messvorrichtung (1) eines Energiezählers (100).

An den Strommesseingang (2) mit der Eingangsimpedanz Z1 ist eine erste Zuleitung (4) angeschlossen, über die der Strommesseingang (2) mit der Sekundärseite eines in dieser Figur nicht gezeigten Stromwandlers (10) verbindbar ist. Primärseitig ist der Stromwandler (10) mit einer Primärleitung koppelbar, durch die der zu bestimmende Strom I fließt. An den Spannungsmesseingang (3) mit der Eingangsimpedanz Z2 ist eine zweite Zuleitung (5) angeschlossen, über die der Spannungsmesseingang (3) mit der Sekundärseite eines in dieser Figur nicht gezeigten Spannungswandlers (20) verbindbar ist. Die Primärseite des Spannungswandlers (20) ist mit der Primärleitung koppelbar, an der die zu bestimmende Spannung U anliegt.

Die mithilfe der Messvorrichtung (1) erfassten Messdaten für Strom und Spannung sind mithilfe einer Speichereinrichtung (6) zumindest vorläufig speicherbar, sodass mithilfe der Kompensationseinheit (7) eine Kompensation der Messdaten zur Bestimmung der kompensierten Primärgrößen I und U ausführbar ist.

Die Eingangsimpedanz Z1 des Strommesseingangs (2) ist niederohmig. In dem dargestellten Ausführungsbeispiel beträgt die Eingangsimpedanz Z1 des Strommesseingangs (2) 1 Ohm. Der Zuleitungswiderstand ZL der ersten Zuleitung (4) beträgt insgesamt 1,5 Ohm (2x 0,75 Ohm). Die Eingangsimpedanz Z2 des Spannungsmesseingangs (3) ist hochohmig und beträgt in dem Beispiel 10 MOhm.

In Figur 2 ist beispielhaft ein elektrisches Ersatzschaltbild eines Stromwandlers (20) dargestellt, wie es in einem erfindungsgemäßen Verfahren dem mathematischen Modell eines Stromwandlers (20) zugrunde liegt.

Bei der Spannung U₁ handelt es sich dabei um die Primärspannung und bei der Spannung U₂ um die Sekundärspannung des Stromwandlers (20). Die Kernspannung des Stromwandlers (20) ist mit U₀ gekennzeichnet. Die Spannung über der Sekundärwicklung des Stromwandlers (20) ist mit Uw bezeichnet. Bezüglich der Ströme bezeichnet I₁ den Primärstrom, I₂ den Sekundärstrom, I₁' den ideal transformierten Primärstrom, I₀ den Magnetisierungsstrom, I_{µ}, den induktiven Anteil des Magnetisierungsstroms I₀ und I_{R} den ohmschen Anteil des Magnetisierungsstroms I₀. Mit P₁ und P₂ sind die Primäranschlüsse bezeichnet, während mit S₁ und S₂ die Sekundärklemmen bezeichnet sind. N₁ bezeichnet die Anzahl der Primärwindungen und N₂ die Anzahl der Sekundärwindungen des Stromwandlers (20). Das Windungszahlverhältnis wird dabei durch N₁/N₂ angegeben. Mit L_{2σ} ist die Sekundärstreuinduktivität, mit R_{CT} der Sekundärwicklungswiderstand, mit X_{B} der induktive Anteil der Bürdenimpedanz, mit R_{B} der ohmsche Anteil der Bürdenimpedanz, mit X_{H} die Hauptinduktivität des Kerns des Stromwandlers (20) und mit R_{Fe} der die Eisenverluste des Stromwandlers (20) repräsentierende Widerstand bezeichnet.

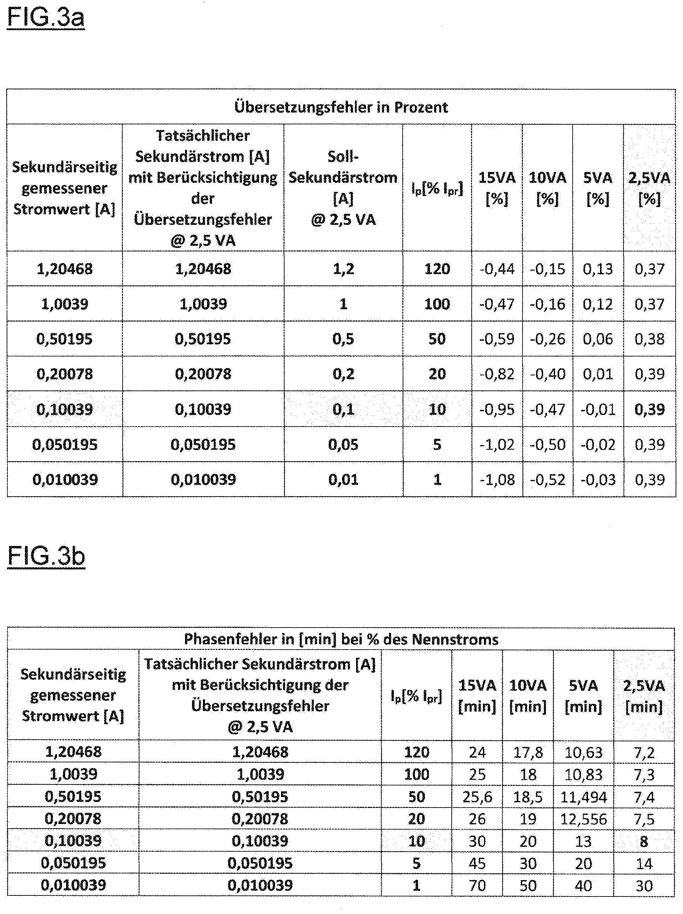

In Figur 3a ist eine beispielhafte Kompensationstabelle zur Kompensation des Betrags des gemessenen Stromes dargestellt, wie es in einem erfindungsgemäßen Verfahren zur Messung von elektrischen Strömen gemäß vorteilhafter Ausführungsformen verwendet wird. Im Zuge der Auslegung des Systems wird für den Stromwandler (20) eine Bemessungsleistung festgelegt.

In einem im weiteren detailliert erläuterten Anwendungsbeispiel beträgt der primäre Nennstrom 100 A, der sekundäre Nennstrom 1 A die Bemessungsnennleistung 10 VA, die Genauigkeitsklasse des Stromwandlers (20) 0,5 und die Bemessungsfrequenz des Primärstromes 50 Hz. Der zu erfassende aktuell anliegende Primärstrom betrage 10 A. Der Zuleitungswiderstand der Zuleitung (4) zwischen Stromwandler (20) und Strommesseingang (2) der Messvorrichtung (1) betrage zweimal 0,75 Ohm und die Eingangsimpedanz Z1 des Strommesseingangs (2) betrage 1 Ohm. Die Bemessungsleistung für den Beispiel-Stromwandler beträgt dann gemäß der Formel P = I²×R: (1 A)² × (2 x 0,75 Ohm +1 Ohm) = 2,5 VA.

Anhand des sekundärseitig gemessenen Stromwertes der beispielhaft 0,10039 A betrage und der Bemessungsleistung, die wie vorstehend berechnet in dem Beispiel 2,5 VA beträgt, kann aus der dargestellten Kompensationstabelle der Fehlerwert für den gemessenen Stromwert ab- bzw. ausgelesen werden. Das Sollübertragungsverhältnis des Stromwandlers (20) beträgt in dem Beispiel 100:1, sodass aus dem kompensierten sekundärseitig gemessenen Stromwert, der nach der Kompensation des Fehlers in Höhe von 0,39 % mit 0,1 A beziffert ist, auf 10 A berechnet werden, was dem gemäß dem Beispiel tatsächlich aktuell durch den Primärleiter fließenden Primärstrom entspricht.

In Figur 3b ist eine analoge Kompensationstabelle für den Phasenfehler des gemessenen Stromes dargestellt. Die Kompensation des Phasenfehlers erfolgt dabei analog zur Kompensation des Betragsfehlers, indem aus der Kompensationstabelle anhand der zuvor bestimmten Bemessungsleistung und dem gemessenen Stromwert der Phasenfehler ab- bzw. ausgelesen wird.

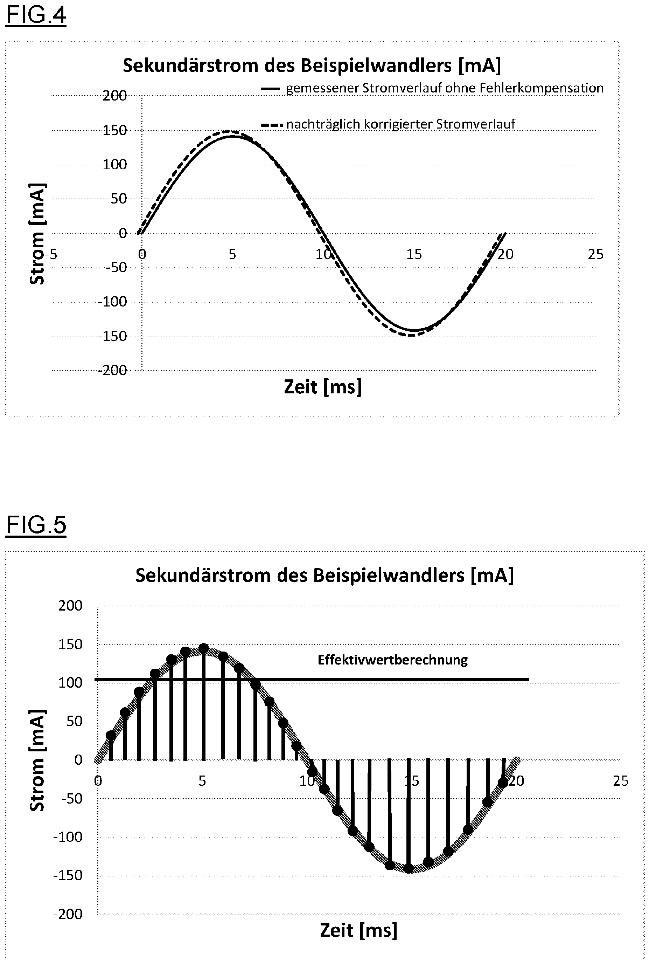

Figur 4 zeigt die Sinuskurven des Sekundärstroms des Stromwandlers (20) aus dem vorstehend definierten Beispiel. Dargestellt ist der Verlauf des tatsächlich gemessenen Sekundärstromes und der des nachträglich kompensierten Stromsignals. Die Kompensation des gemessenen Stromsignals erfolgte dabei anhand der in den Figuren 3a und 3b dargestellten Kompensationstabellen in Betrag und Phase.

Figur 5 zeigt die tatsächliche Behandlung des Sekundärstroms durch die Messvorrichtung (1). Mit dieser wird der Sekundärstrom an diskreten Zeitpunkten abgetastet, die in der Figur durch die schwarzen Linien mit kreisrundem Kopf dargestellt sind. Aus den Abtastwerten ist der tatsächliche Stromverlauf rekonstruierbar. Eine unmittelbare Korrektur der diskreten Abtastwerte ist dabei in Ausführungsformen der Erfindung nicht möglich, da die Stromwerte in den entsprechenden Kompensationstabellen als Effektivwerte vorliegen. Um dann eine nachträgliche Korrektur der Abtastwerte vorzunehmen, wird in der Messvorrichtung der relevante Effektivwert über eine komplette Sinusschwingung berechnet. Dazu werden die Abtastwerte des Strommesseingangs (2) der Messvorrichtung (1) mit den zugehörigen Abtastwerten vom Spannungsmesseingang (3) mithilfe einer Speichervorrichtung (6) abgespeichert. In anderen Ausführungsformen der Erfindung wird der Effektivwert über ein kürzeres Intervall abgeschätzt. Aus der Kompensationstabelle ist nun beispielsweise für den Betrag ablesbar, dass bei einem Effektivwert des sekundärseitig gemessenen Stromes in Höhe von 0,10039 A bei einer Bemessungsleistung von 2,5 VA letztendlich ein Soll-Sekundärstrom von 0,1 A vorliegt. Analog ist dann mit dem Phasenfehler bzw. der Kompensation des Phasenfehlers mithilfe der entsprechenden Kompensationstabelle zu verfahren.

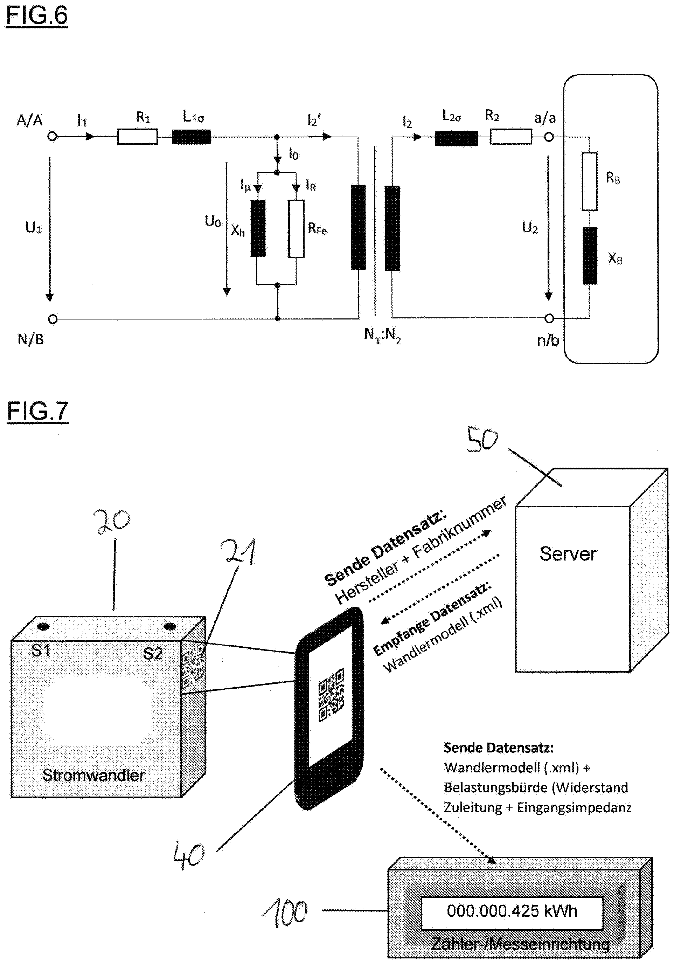

In Figur 6 ist das elektrische Ersatzschaltbild eines Spannungswandlers (30) dargestellt, wie es als Grundlage eines mathematischen Modells eines Spannungswandlers (30) in Ausführungsformen eines erfindungsgemäßen Verfahrens verwendet wird. U₁ kennzeichnet dabei die Primärspannung, U₂ die Sekundärspannung und U₀ die Kernspannung des Spannungswandlers (30). I₁ kennzeichnet den Primärstrom, I₂ kennzeichnet den Sekundärstrom, I₂' den transformierten Sekundärstrom, I₀ den Magnetisierungsstrom, I_{µ} den induktiven Anteil des Magnetisierungsstroms I₀ und I_{R} den ohmschen Anteil des Magnetisierungsstroms I₀. Die Primäranschlüsse sind mit A/A und N/B und die Sekundärklemmen mit a/a und n/b gekennzeichnet. N₁ gibt die Anzahl der Primärwindungen und N₂ die Anzahl der Sekundärwindungen des Spannungswandlers (30) an. Das Windungszahlverhältnis des Spannungswandlers (30) ist durch N₁/N₂ gekennzeichnet. L_{1σ} bezeichnet die Primärstreuinduktivitäten, R₁ den Primärwicklungswiderstand, L_{2σ} die Sekundärstreuinduktivitäten, R₂ den Sekundärwicklungswiderstand, X_{B} den induktiven Anteil der Bürdenimpedanz, R_{B} den ohmschen Anteil der Bürdenimpedanz, X_{H} die Hauptinduktivität des Kerns, und R_{Fe} den die Eisenverluste des Spannungswandlers (30) repräsentierenden Widerstand.

Figur 7 zeigt eine schematische Darstellung der Verfahrensschritte zum Aufspielen des mathematischen Modells eines Stromwandlers (20) auf einen Energiezähler (100). Mithilfe einer Übertragungsvorrichtung (40), die in dem Beispiel als ein Smartphone ausgebildet ist, wird die auf dem Stromwandler (20) angebrachte Kodierung (21) ausgelesen. Die Kodierung (21) des Stromwandlers (20) enthält in dem Beispiel eine Herstellerkennung und eine Seriennummer des Stromwandlers (20). Die mithilfe der Übertragungsvorrichtung (40) ausgelesenen Daten bezüglich des Stromwandlers (20) werden über eine Internetverbindung an einen Server (50) übertragen, von dem das mathematische Modell des entsprechenden Stromwandlers (20) mithilfe der Übertragungsvorrichtung (40) abgerufen wird. Das mathematische Modell des Stromwandlers (20) und/oder die zugehörigen Kompensationstabellen werden dann von der Übertragungsvorrichtung (40) über eine geeignete Schnittstelle an den Energiezähler (100) übertragen und in eine Speichervorrichtung (6) des Energiezählers (100) gespeichert.

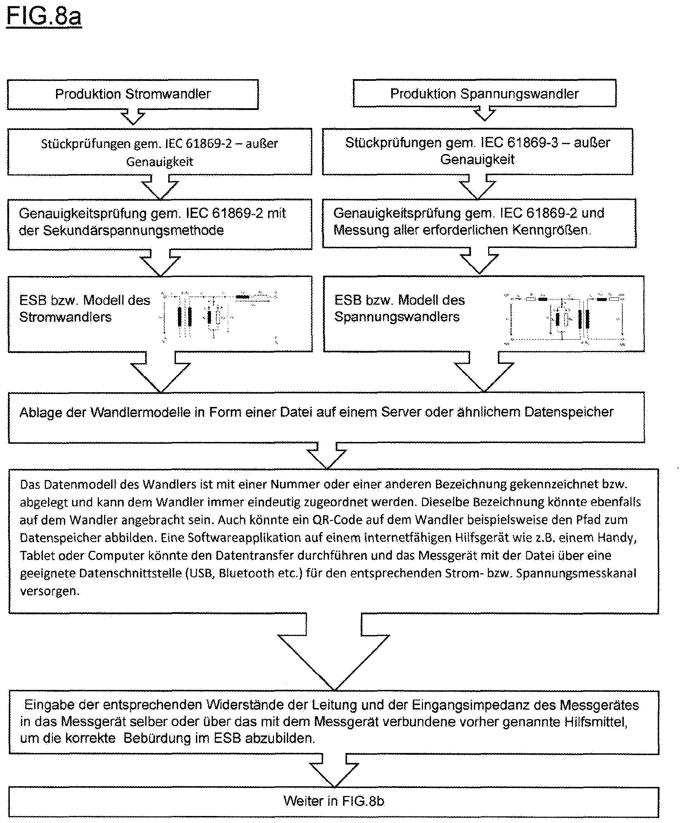

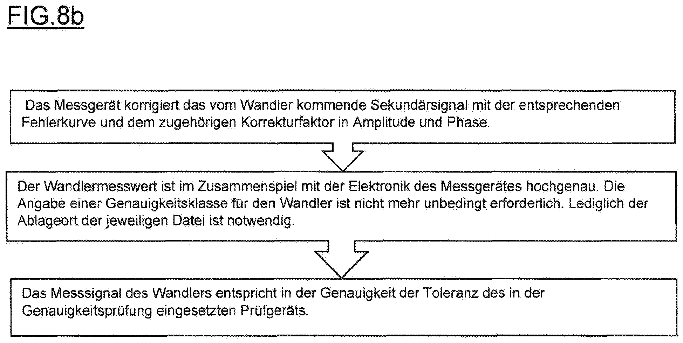

In den Figuren 8a und 8b ist schematisch der Ablauf eines erfindungsgemäßen Verfahrens für das Beispiel einer Kompensation für einen Stromwandler (20) und einen Spannungswandler (30) dargestellt. Nach der Produktion der entsprechenden Wandler werden mithilfe geeigneter Messungen mathematische Modelle der entsprechenden Wandler erzeugt, die beispielsweise durch deren elektrische Ersatzschaltbilder gegeben sein können. Diese mathematischen Modelle der Wandler werden in Form einer Datei auf einem Server oder einem ähnlich zugänglichen Datenspeicher abgelegt. Durch die Kopplung der mathematischen Modelle der entsprechenden Wandler mit den jeweiligen eindeutigen Bezeichnungen, beispielsweise der Seriennummer und/oder ein einer Herstellerkennung, sind die mathematischen Modelle entsprechend mit geeigneten Übertragungsvorrichtungen (40), die beispielsweise als ein Smartphone, Tablet oder PC ausgebildet sein können, abgerufen werden. Dazu sind in Ausführungsformen der Erfindung geeignete Software-Applikationen auf den entsprechenden Übertragungsvorrichtungen (40) installiert. Das mithilfe der Übertragungsvorrichtung (40) abgerufene Modell des Strom- und/oder Spannungswandlers ist dann mithilfe der Übertragungsvorrichtung (40) über eine geeignete Datenschnittstelle, wie beispielsweise USB, Bluetooth etc. an die Messvorrichtung (1) übertragbar. In einer besonders vorteilhaften Ausführungsform des erfindungsgemäßen Verfahrens werden die mathematischen Modelle des Stromwandlers (20) und/oder des Spannungswandlers (30) durch die Eingabe der entsprechenden Widerstände der Zuleitungen und der Eingangsimpedanz der Messvorrichtung (1) mithilfe der Übertragungsvorrichtung (40) oder an der Messvorrichtung (1) selbst ergänzt, um eine erhöhte Genauigkeit der Kompensation zu erreichen. Die entsprechend konfigurierte Messvorrichtung (1) kompensiert das vom jeweiligen Wandler kommende Sekundärsignal mithilfe der Kompensationseinheit (7) unter Verwendung der jeweiligen Kompensationstabellen in Amplitude und/oder Phase. Die kompensierten Messwerte sind im Zusammenspiel mit Elektronik der Messvorrichtung (1) hochgenau. Durch die Kompensation der wandlerbedingten Fehlereinflüsse ist eine Verwendung hochgenauer Wandler nicht mehr unbedingt erforderlich, sodass entsprechend kostengünstigere Wandler einsetzbar sind. Die Genauigkeit der Messergebnisse hängt letztlich von der Genauigkeit der mathematischen Modelle ab.

## Patentansprüche

1. Verfahren zur Messung elektrischer Ströme, wobei ein durch einen Primärleiter fließender Primärstrom mithilfe eines induktiven Stromwandlers (20), der eine Primärseite und eine galvanisch von der Primärseite getrennte Sekundärseite aufweist, in einen betragsmäßig kleineren Sekundärstrom gewandelt wird und wobei in einem Verfahrensschritt der Sekundärstrom mithilfe einer Messvorrichtung (1) gemessen wird und in einem weiteren Verfahrensschritt mindestens eine auf einem mathematischen Modell des Stromwandlers (20) basierende Kompensationstabelle für den Betrag und/oder die Phase des gemessenen Sekundärstroms aus einer Speichereinrichtung (6) geladen oder aus dem mathematischen Modell des Stromwandlers (20) erzeugt wird und die mindestens eine Kompensationstabelle in einem weiteren Verfahrensschritt dazu verwendet wird, die Abweichung des Messsignals in Betrag und/oder Phase zumindest teilweise zu kompensieren, und der durch den Primärleiter fließende Primärstrom auf Basis des kompensierten Sekundärstromes rekonstruiert wird, **dadurch gekennzeichnet, dass** das mathematische Modell des Stromwandlers (20) die tatsächliche Bebürdung des Stromwandlers (20) im Sinne der Eingangsimpedanz der Messvorrichtung (1) und der Leitungsimpedanz der Leitung vom Stromwandler (20) zur Messvorrichtung (1) berücksichtigt, wobei die Leitungsimpedanz der Leitung zwischen Stromwandler (20) und Messvorrichtung (1) im mathematischen Modell durch die Eingabe der gemessenen Leitungsimpedanz oder deren Auswahl aus einer vorgegebenen Liste oder durch den aus einer Eingabe der Leitungslänge und des Querschnitts automatisch berechneten Wert ergänzt wird.

2. Verfahren zur Messung elektrischer Ströme nach Anspruch 1, **dadurch gekennzeichnet, dass** das mathematische Modell des Stromwandlers (20) auf einem elektrischen Ersatzschaltbild des Stromwandlers (20) basiert.

3. Verfahren zur Messung elektrischer Ströme nach mindestens einem der vorstehenden Ansprüche, **dadurch gekennzeichnet, dass** in einem Energiezähler (100) der Fehlereinfluss des angeschlossenen Stromwandlers (20) zumindest teilweise kompensiert wird.

4. Verfahren zur Messung elektrischer Ströme nach mindestens einem der vorstehenden Ansprüche, **dadurch gekennzeichnet, dass** in einem Verfahrensschritt mithilfe einer Übertragungsvorrichtung (40) eine typenbezogene Kodierung (21) eines mit einem Energiezähler (100) verbundenen oder mit diesem Energiezähler (100) zu verbindenden Stromwandlers (20) ausgelesen wird, dass in einem weiteren Verfahrensschritt mithilfe der ausgelesenen Kodierung (21) ein mathematisches Modell des jeweiligen Stromwandlers (20) von einem Webserver (50) auf die Übertragungsvorrichtung (40) heruntergeladen wird, dass in einem weiteren Verfahrensschritt das mathematische Modell des jeweiligen Stromwandlers (20) über eine Schnittstelle an den Energiezähler (100) übermittelt wird und dass das mathematische Modell des Stromwandlers (20) in einem weiteren Verfahrensschritt in einer Speichereinrichtung (6) des Energiezählers (100) gespeichert wird.

5. Verfahren zur Messung elektrischer Ströme nach mindestens einem der Ansprüche 1 bis 3, **dadurch gekennzeichnet, dass** in einem Verfahrensschritt mithilfe einer Übertragungsvorrichtung (40) eine typenbezogene Kodierung (21) eines mit einem Energiezähler (100) verbundenen oder mit diesem Energiezähler (100) zu verbindenden Stromwandlers (20) ausgelesen wird, dass in einem weiteren Verfahrensschritt mithilfe der ausgelesenen Kodierung (21) ein mathematisches Modell des jeweiligen Stromwandlers (20) von einem Webserver (50) auf die Übertragungsvorrichtung (40) heruntergeladen wird, dass in einem weiteren Verfahrensschritt aus dem mathematischen Modell des jeweiligen Stromwandlers (20) mithilfe der Übertagungsvorrichtung (40) mindestens eine Kompensationstabelle erzeugt wird und dass die mindestens eine Kompensationstabelle über eine Schnittstelle an den Energiezähler (100) übermittelt wird und dass die mindestens eine Kompensationstabelle in einem weiteren Verfahrensschritt in einer Speichereinrichtung (6) des Energiezählers (100) gespeichert wird.

6. Verfahren zur Messung elektrischer Ströme nach mindestens einem der Ansprüche 4 und 5, **dadurch gekennzeichnet, dass** die typenbezogene Kodierung (21) des Stromwandlers (20) einen Downloadlink zum Download des mathematischen Modells oder der Kompensationstabelle des Stromwandlers (20) von einem Webserver (50) enthält.

7. Verfahren zur Messung elektrischer Ströme nach mindestens einem der Ansprüche 1 bis 3, **dadurch gekennzeichnet, dass** in einem Verfahrensschritt mithilfe einer Übertragungsvorrichtung (40) eine typenbezogene Kodierung (21) eines mit einem Energiezähler (100) verbundenen oder mit diesem Energiezähler (100) zu verbindenden Stromwandlers (20) ausgelesen wird, dass in einem weiteren Verfahrensschritt mithilfe der ausgelesenen Kodierung (21) ein mathematisches Modell des jeweiligen Stromwandlers (20) auf einem PC aufgerufen oder auf der Übertragungsvorrichtung (40) ausgewählt wird, dass in einem weiteren Verfahrensschritt auf dem PC mindestens eine Kompensationstabelle aus dem mathematischen Modell des jeweiligen Stromwandlers (20) erzeugt und in einem weiteren Verfahrensschritt auf die Übertragungsvorrichtung (40) heruntergeladen wird oder dass aus dem auf der Übertragungsvorrichtung (40) ausgewählten mathematischen Modell eine Kompensationstabelle erzeugt wird, dass in einem weiteren Verfahrensschritt die mindestens eine Kompensationstabelle über eine Schnittstelle von der Übertragungsvorrichtung (40) an den Energiezähler (100) übermittelt wird und dass die mindestens eine Kompensationstabelle in einem weiteren Verfahrensschritt in einer Speichereinrichtung (6) des Energiezählers (100) gespeichert wird.

8. Verfahren zur Messung elektrischer Ströme nach einem der Ansprüche 4 bis 7, **dadurch gekennzeichnet, dass** das mathematische Modell des Stromwandlers (20) in einem Verfahrensschritt mithilfe der Übertragungsvorrichtung (40) um die Impedanz der Leitung zwischen dem Stromwandler (20) und dem Energiezähler (100) und/oder die Eingangsimpedanz der Messvorrichtung (1) des Energiezählers (100) ergänzt wird.

9. Verfahren zur Messung elektrischer Spannungen, wobei eine an einem Primärleiter anliegende Primärspannung mithilfe eines induktiven Spannungswandlers (30), der eine Primärseite und eine galvanisch von der Primärseite getrennte Sekundärseite aufweist, in eine betragsmäßig kleinere Sekundärspannung gewandelt wird, wobei in einem Verfahrensschritt die Sekundärspannung mithilfe einer Messvorrichtung (1) gemessen wird, in einem weiteren Verfahrensschritt mindestens eine auf einem mathematischen Modell des Spannungswandlers (30) basierende Kompensationstabelle für den Betrag und/oder die Phase der gemessenen Sekundärspannung aus einer Speichereinrichtung (6) geladen oder aus dem mathematischen Modell des Spannungswandlers (30) erzeugt wird und die mindestens eine Kompensationstabelle in einem weiteren Verfahrensschritt dazu verwendet wird, die Abweichung des Messsignals in Betrag und/oder Phase zumindest teilweise zu kompensieren, und wobei die an dem Primärleiter anliegende Primärspannung auf Basis der kompensierten Sekundärspannung rekonstruiert wird, **dadurch gekennzeichnet, dass** das mathematische Modell des Spannungswandlers (30) die tatsächliche Bebürdung des Spannungswandlers (30) im Sinne der Eingangsimpedanz der Messvorrichtung (1) und der Leitungsimpedanz der Leitung vom Spannungswandler (30) zur Messvorrichtung (1) berücksichtigt, wobei die Leitungsimpedanz der Leitung zwischen Spannungswandler (30) und Messvorrichtung (1) im mathematischen Modell durch die Eingabe der gemessenen Leitungsimpedanz oder deren Auswahl aus einer vorgegebenen Liste oder durch den aus einer Eingabe der Leitungslänge und des Querschnitts automatisch berechneten Wert ergänzt wird.

10. Verfahren zur Messung elektrischer Spannungen nach Anspruch 9, **dadurch gekennzeichnet, dass** das mathematische Modell des Spannungswandlers (30) auf einem elektrischen Ersatzschaltbild des Spannungswandlers (30) basiert.

11. Verfahren zur Messung elektrischer Spannungen nach mindestens einem der Ansprüche 9 und 10, **dadurch gekennzeichnet, dass** in einem Energiezähler (100) der Fehlereinfluss des angeschlossenen Spannungswandlers (30) zumindest teilweise kompensiert wird.

12. Verfahren zur Messung elektrischer Spannungen nach mindestens einem der Ansprüche 9 bis 11, **dadurch gekennzeichnet, dass** in einem Verfahrensschritt mithilfe einer Übertragungsvorrichtung (40) eine typenbezogene Kodierung (21) eines mit einem Energiezähler (100) verbundenen oder mit diesem Energiezähler (100) zu verbindenden Spannungswandlers (30) ausgelesen wird, dass in einem weiteren Verfahrensschritt mithilfe der ausgelesenen Kodierung (21) ein mathematisches Modell des jeweiligen Spannungswandlers (30) von einem Webserver (50) auf die Übertragungsvorrichtung (40) heruntergeladen wird, dass in einem weiteren Verfahrensschritt das mathematische Modell des jeweiligen Spannungswandlers (30) über eine Schnittstelle an den Energiezähler (100) übermittelt wird und dass das mathematische Modell des Spannungswandlers (30) in einem weiteren Verfahrensschritt in einer Speichereinrichtung (6) des Energiezählers (100) gespeichert wird.

13. Verfahren zur Messung elektrischer Spannungen nach Anspruch 12, **dadurch gekennzeichnet, dass** die typenbezogene Kodierung (21) des Spannungswandlers (30) einen Downloadlink zum Download des mathematischen Modells oder der Kompensationstabelle des Stromwandlers (20) von einem Webserver (50) enthält.

14. Verfahren zur Messung elektrischer Spannungen nach einem der Ansprüche 12 und 13, **dadurch gekennzeichnet, dass** das mathematische Modell des Spannungswandlers (30) in einem Verfahrensschritt mithilfe der Übertragungsvorrichtung (40) um die Impedanz der Leitung zwischen dem Spannungswandler (30) und dem Energiezähler (100) und/oder die Eingangsimpedanz der Messvorrichtung (1) des Energiezählers (100) ergänzt wird.

15. Energiezähler (100) zur Messung des Energieverbrauches mindestens eines an mindestens einen Primärleiter angeschlossenen Verbrauchers, der Energiezähler (100) aufweisend mindestens einen Strommesseingang (2) und mindestens einen Spannungsmesseingang (3) zur Messung jeweils eines Stromes bzw. einer Spannung, wobei der Energiezähler (100) eine Kompensationseinheit (7) zur Kompensation des Fehlereinflusses eines an einen Strommesseingang (2) angeschlossenen Stromwandlers (20) auf das mindestens eine gemessene Stromsignal und/oder des Fehlereinflusses eines an einen Spannungsmesseingang (3) angeschlossenen Spannungswandlers (30) auf das mindestens eine gemessene Spannungssignal aufweist, wobei das mindestens eine gemessene Strom- und/oder Spannungssignal dadurch kompensierbar ist, dass mithilfe der Kompensationseinheit (7) mindestens eine Kompensationstabelle zur Kompensation des jeweiligen Messsignals in Betrag und/oder Phase basierend auf dem mathematischen Modell des jeweiligen Stromwandlers (20) bzw. Spannungswandlers (30) ladbar oder erzeugbar ist und dass die mindestens eine Kompensationstabelle zur Kompensation des jeweiligen Messsignals in Betrag und/oder Phase auf das jeweilige Messsignal anwendbar ist, **dadurch gekennzeichnet, dass** das mathematische Modell des Stromwandlers (20) und/oder des Spannungswandlers (30) die tatsächliche Bebürdung des Stromwandlers (20) bzw. des Spannungswandlers (30) im Sinne der Eingangsimpedanz der Messvorrichtung (1) und der Leitungsimpedanz der Leitung vom Stromwandler (20) bzw. Spannungswandler (30) zur Messvorrichtung (1) berücksichtigt, wobei die Leitungsimpedanz der Leitung zwischen dem Stromwandler (20) und/oder dem Spannungswandler (30) und der Messvorrichtung (1) im mathematischen Modell durch die Eingabe der gemessenen Leitungsimpedanz oder deren Auswahl aus einer vorgegebenen Liste oder durch den aus einer Eingabe der Leitungslänge und des Querschnitts automatisch berechneten Wert ergänzt wird.

## Claims

1. A method for measuring electric currents, wherein a primary current flowing through a primary conductor is converted into a secondary current of smaller magnitude using an inductive current converter (20) which has a primary side and a secondary side which is DC-isolated from the primary side, an wherein in one method step, the secondary current is measured using a measuring apparatus (1), in that, in a further method step, at least one compensation table based on a mathematical model of the current converter (20) for the magnitude and/or the phase of the measured secondary current is loaded from a memory device (6) or is generated from the mathematical model of the current converter (20), and in that the at least one compensation table is used in a further step to at least partly compensate for the deviation of the measurement signal in magnitude and/or phase, and in that the primary current flowing through the primary conductor is reconstructed on the basis of the compensated secondary current, **characterized in that** the mathematical model of the current converter (20) takes into account the actual burden on the current converter (20) in terms of the input impedance of the measuring apparatus (1) and the line resistance of the line from the current converter (20) to the measuring apparatus (1), wherein the line impedance of the line between the current converter (20) and the measuring apparatus (1) is supplemented in the mathematical model by the input of the measured line impedance or its selection from a predetermined list or by the value automatically calculated from an input of the line length and the cross-section.

2. The method for measuring electric currents as claimed in claim 1, **characterized in that** the mathematical model of the current converter (20) is based on an electrical equivalent circuit diagram of the current converter (20).

3. The method for measuring electric currents as claimed in at least one of the preceding claims, **characterized in that** the error effect of the connected current converter (20) is at least partly compensated for in an energy meter (100).

4. The method for measuring electric currents as claimed in at least one of the preceding claims, **characterized in that**, in one method step, a type-related coding (21) of a current converter (20) connected to an energy meter (100) or to be connected to said energy meter (100) is read out using a transmission apparatus (40), **in that**, in a further method step, a mathematical model of the respective current converter (20) is downloaded from a web server (50) onto the transmission apparatus (40) using the coding (21) read out, **in that**, in a further method step, the mathematical model of the respective current converter (20) is transmitted to the energy meter (100) via an interface, and **in that** the mathematical model of the current converter (20) is stored in a memory device (6) of the energy meter (100) in a further method step.

5. The method for measuring electric currents as claimed in at least one of claims 1 to 3, **characterized in that**, in one method step, a type-related coding (21) of a current converter (20) connected to an energy meter (100) or to be connected to said energy meter (100) is read out using a transmission apparatus (40), **in that**, in a further method step, a mathematical model of the respective current converter (20) is downloaded from a web server (50) onto the transmission apparatus (40) using the coding (21) read out, **in that**, in a further method step, at least one compensation table is generated from the mathematical model of the respective current converter (20) using the transmission apparatus (40), and **in that** the at least one compensation table is transmitted to the energy meter (100) via an interface, and **in that** the at least one compensation table is stored in a memory device (6) of the energy meter (100) in a further method step.

6. The method for measuring electric currents as claimed in at least one of the claims 4 and 5, **characterized in that** the type-related coding (21) of the current converter (20) contains a download link for downloading the mathematical model or the compensation table of the current converter (20) from a web server (50).

7. The method for measuring electric currents as claimed in at least one of claims 1 to 3, **characterized in that**, in one method step, a type-related coding (21) of a current converter (20) connected to an energy meter (100) or to be connected to said energy meter (100) is read out using a transmission apparatus (40), **in that**, in a further method step, a mathematical model of the respective current converter (20) is accessed on a PC or is selected on the transmission apparatus (40) using the coding (21) read out, **in that**, in a further method step, at least one compensation table is generated from the mathematical model of the respective current converter (20) on the PC, and, in a further method step, is downloaded onto the transmission apparatus (40) or **in that** a compensation table is generated from the mathematical model selected on the transmission apparatus (40), **in that**, in a further method step, the at least one compensation table is transmitted from the transmission apparatus (40) to the energy meter (100) via an interface, and **in that** the at least one compensation table is stored in a memory device (6) of the energy meter (100) in a further method step.

8. The method for measuring electric currents as claimed in one of claims 4 to 7, **characterized in that**, in one method step, the mathematical model of the current converter (20) is supplemented, using the transmission apparatus (40), with the impedance of the line between the current converter (20) and the energy meter (100) and/or the input impedance of the measuring apparatus (1) of the energy meter (100).

9. A method for measuring electrical voltages, wherein a primary voltage applied to a primary conductor is converted into a secondary voltage of smaller magnitude using an inductive voltage converter (30) which has a primary side and a secondary side which is DC-isolated from the primary side, wherein in one method step, the secondary voltage is measured using a measuring apparatus (1), in that, in a further method step, at least one compensation table based on a mathematical model of the voltage converter (30) for the magnitude and/or the phase of the measured secondary voltage is loaded from a memory device (6) or is generated from the mathematical model of the voltage converter (30), and in that the at least one compensation table is used in a further method step to at least partly compensate for the deviation of the measurement signal in magnitude and/or phase, and in that the primary voltage applied to the primary conductor is reconstructed on the basis of the compensated secondary voltage, **characterized in that** the mathematical model of the voltage converter (30) takes into account the actual burden on the voltage converter (30) in terms of the input impedance of the measuring apparatus (1) and the line resistance of the line from the voltage converter (30) to the measuring apparatus (1), wherein the line impedance of the line between the voltage converter (30) and the measuring apparatus (1) is supplemented in the mathematical model by the input of the measured line impedance or its selection from a predetermined list or by the value automatically calculated from an input of the line length and the cross-section.

10. The method for measuring electrical voltages as claimed in claim 9, **characterized in that** the mathematical model of the voltage converter (30) is based on an electrical equivalent circuit diagram of the voltage converter (30).

11. The method for measuring electrical voltages as claimed in at least one of claims 9 and 10, **characterized in that** the error effect of the connected voltage converter (30) is at least partly compensated for in an energy meter (100).

12. The method for measuring electrical voltages as claimed in at least one of claims 9 to 11, **characterized in that**, in one method step, a type-related coding (21) of a voltage converter (30) connected to an energy meter (100) or to be connected to said energy meter (100) is read out using a transmission apparatus (40), **in that**, in a further method step, a mathematical model of the respective voltage converter (30) is downloaded from a web server (50) onto the transmission apparatus (40) using the coding (21) read out, **in that**, in a further method step, the mathematical model of the respective voltage converter (30) is transmitted to the energy meter (100) via an interface, and **in that** the mathematical model of the voltage converter (30) is stored in a memory device (6) of the energy meter (100) in a further method step.

13. The method for measuring electrical voltages as claimed in claim 12, **characterized in that** the type-related coding (21) of the voltage converter (30) contains a download link for downloading the mathematical model or the compensation table of the current converter (20) from a web server (50).

14. The method for measuring electrical voltages as claimed in one of claims 12 and 13, **characterized in that**, in one method step, the mathematical model of the voltage converter (30) is supplemented, using the transmission apparatus (40), with the impedance of the line between the voltage converter (30) and the energy meter (100) and/or the input impedance of the measuring apparatus (1) of the energy meter (100).

15. An energy meter (100) for measuring the energy consumption of at least one consumer connected to at least one primary conductor, the energy meter (100) having at least one current measurement input (2) and at least one voltage measurement input (3) for measuring a current or a voltage in each case, wherein the energy meter (100) has a compensation unit (7) for compensating for the error effect of a current converter (20) connected to a current measurement input (2) onto the at least one measured current signal and/or the error effect of a voltage converter (30) connected to a voltage measurement input (3) onto the at least one measured voltage signal, wherein the at least one measured current and/or voltage signal can be compensated for by virtue of at least one compensation table for compensating the respective measurement signal in magnitude and/or phase based on the mathematical model of the respective current converter (20) or voltage converter (30) being able to be loaded or generated using the compensation unit (7), and in that the at least one compensation table for compensating for the respective measurement signal in magnitude and/or phase can be applied to the respective measurement signal, **characterized in that** the mathematical model of the current converter (20) and/or of the voltage converter (30) takes into account the actual burden of the current converter (20) and/or of the voltage converter (30) in the sense of the input impedance of the measuring apparatus (1) and the line impedance of the line from the current converter (20) or voltage converter (30) to the measuring apparatus (1) is taken into account, the line impedance of the line between the current converter (20) and/or the voltage converter (30) and the measuring apparatus (1) being supplemented in the mathematical model by the input of the measured line impedance or its selection from a predetermined list or by the value automatically calculated from an input of the line length and the cross section.

## Revendications

1. Procédé pour mesurer des courants électriques, un courant primaire qui s'écoule à travers un conducteur primaire étant converti en un courant secondaire de valeur plus petite à l'aide d'un convertisseur de courant (20) inductif, lequel possède un côté primaire et un côté secondaire isolé galvaniquement du côté primaire, et dans une étape du procédé, le courant secondaire étant mesuré à l'aide d'un arrangement de mesure (1) et, dans une étape du procédé supplémentaire, au moins un tableau de compensation basé sur un modèle mathématique du convertisseur de courant (20) pour la valeur et/ou la phase du courant secondaire mesurée étant chargé depuis un dispositif de mémorisation (6) ou généré à partir du modèle mathématique du convertisseur de courant (20) et l'au moins un tableau de compensation étant utilisé dans une étape du procédé supplémentaire pour compenser au moins partiellement l'écart du signal de mesure en valeur et/ou en phase, et le courant primaire qui s'écoule à travers le conducteur primaire étant reconstruit sur la base du courant secondaire compensé, **caractérisé en ce que** le modèle mathématique du convertisseur de courant (20) tient compte de la mise en charge réelle du convertisseur de courant (20) dans le sens de l'impédance d'entrée de l'arrangement de mesure (1) et de l'impédance de ligne de la ligne du convertisseur de courant (20) à l'arrangement de mesure (1), l'impédance de ligne entre le convertisseur de courant (20) et l'arrangement de mesure (1) dans le modèle mathématique étant complétée par la saisie de l'impédance de ligne mesurée ou de sa sélection à partir d'une liste prédéfinie ou par une valeur calculée automatiquement à partir d'une saisie de la longueur de ligne et de la section transversale.

2. Procédé pour mesurer des courants électriques selon la revendication 1, **caractérisé en ce que** le modèle mathématique du convertisseur de courant (20) se base sur un schéma électrique équivalent du convertisseur de courant (20).

3. Procédé pour mesurer des courants électriques selon au moins l'une des revendications précédentes, **caractérisé en ce que** l'influence de l'erreur du convertisseur de courant (20) raccordé est au moins partiellement compensée dans un compteur d'énergie (100).

4. Procédé pour mesurer des courants électriques selon au moins l'une des revendications précédentes, **caractérisé en ce que** dans une étape du procédé, un codage (21) rapporté au type d'un convertisseur de courant (20) connecté au compteur d'énergie (100) ou à connecter à ce compteur d'énergie (100) est lu à l'aide d'un arrangement de transmission (40), **en ce que** dans une étape supplémentaire du procédé, un modèle mathématique du convertisseur de courant (20) respectif est téléchargé depuis un serveur Web (50) sur l'arrangement de transmission (40) à l'aide du codage (21) lu, **en ce que** dans une étape supplémentaire du procédé, le modèle mathématique du convertisseur de courant (20) respectif est communiqué au compteur d'énergie (100) par le biais d'une interface et **en ce que** dans une étape supplémentaire du procédé, le modèle mathématique du convertisseur de courant (20) est mémorisé dans un dispositif de mémorisation (6) du compteur d'énergie (100) .

5. Procédé pour mesurer des courants électriques selon au moins l'une des revendications 1 à 3, **caractérisé en ce que** dans une étape du procédé, un codage (21) rapporté au type d'un convertisseur de courant (20) connecté au compteur d'énergie (100) ou à connecter à ce compteur d'énergie (100) est lu à l'aide d'un arrangement de transmission (40), **en ce que** dans une étape supplémentaire du procédé, un modèle mathématique du convertisseur de courant (20) respectif est téléchargé depuis un serveur Web (50) sur l'arrangement de transmission (40) à l'aide du codage (21) lu, **en ce que** dans une étape supplémentaire du procédé, au moins un tableau de compensation est généré à partir du modèle mathématique du convertisseur de courant (20) respectif à l'aide de l'arrangement de transmission (40) et **en ce que** l'au moins un tableau de compensation est communiqué au compteur d'énergie (100) par le biais d'une interface et **en ce que** dans une étape supplémentaire du procédé, l'au moins un tableau de compensation est mémorisé dans un dispositif de mémorisation (6) du compteur d'énergie (100) .

6. Procédé pour mesurer des courants électriques selon au moins l'une des revendications 4 et 5, **caractérisé en ce que** le codage (21) rapporté au type du convertisseur de courant (20) contient un lien de téléchargement servant au téléchargement du modèle mathématique ou du tableau de compensation du convertisseur de courant (20) depuis un serveur Web (50).

7. Procédé pour mesurer des courants électriques selon au moins l'une des revendications 1 à 3, **caractérisé en ce que** dans une étape du procédé, un codage (21) rapporté au type d'un convertisseur de courant (20) connecté au compteur d'énergie (100) ou à connecter à ce compteur d'énergie (100) est lu à l'aide d'un arrangement de transmission (40), **en ce que** dans une étape supplémentaire du procédé, un modèle mathématique du convertisseur de courant (20) respectif est invoqué sur un PC ou sélectionné sur l'arrangement de transmission (40) à l'aide du codage (21) lu, **en ce que** dans une étape supplémentaire du procédé, au moins un tableau de compensation est généré sur le PC à partir du modèle mathématique du convertisseur de courant (20) respectif et, dans une étape supplémentaire du procédé, téléchargé sur l'arrangement de transmission (40) ou **en ce qu'**un tableau de compensation est généré à partir du modèle mathématique sélectionné sur l'arrangement de transmission (40), et **en ce que** dans une étape supplémentaire du procédé, l'au moins un tableau de compensation est communiqué au compteur d'énergie (100) par le biais d'une interface de l'arrangement de transmission (40) et **en ce que** dans une étape supplémentaire du procédé, l'au moins un tableau de compensation est mémorisé dans un dispositif de mémorisation (6) du compteur d'énergie (100).

8. Procédé pour mesurer des courants électriques selon au moins l'une des revendications 4 à 7, **caractérisé en ce que** dans une étape du procédé, le modèle mathématique du convertisseur de courant (20) est complété à l'aide de l'arrangement de transmission (40) de l'impédance de la ligne entre le convertisseur de courant (20) et le compteur d'énergie (100) et/ou l'impédance d'entrée de l'arrangement de mesure (1) du compteur d'énergie (100).

9. Procédé pour mesurer des tensions électriques, une tension primaire appliquée à un conducteur primaire étant convertie en une tension secondaire de valeur plus petite à l'aide d'un convertisseur de tension (30) inductif, lequel possède un côté primaire et un côté secondaire isolé galvaniquement du côté primaire, dans une étape du procédé, la tension secondaire étant mesurée à l'aide d'un arrangement de mesure (1), dans une étape supplémentaire du procédé, au moins un tableau de compensation basé sur un modèle mathématique du convertisseur de tension (30) pour la valeur et/ou la phase de la tension secondaire mesurée étant chargé depuis un dispositif de mémorisation (6) ou généré à partir du modèle mathématique du convertisseur de tension (30) et l'au moins un tableau de compensation étant utilisé dans une étape supplémentaire du procédé pour compenser au moins partiellement l'écart du signal de mesure en valeur et/ou en phase, et la tension primaire appliquée au conducteur primaire étant reconstruite sur la base de la tension secondaire compensée, **caractérisé en ce que** le modèle mathématique du convertisseur de tension (30) tient compte de la mise en charge réelle du convertisseur de tension (30) dans le sens de l'impédance d'entrée de l'arrangement de mesure (1) et de l'impédance de ligne de la ligne du convertisseur de tension (30) à l'arrangement de mesure (1), l'impédance de ligne entre le convertisseur de tension (30) et l'arrangement de mesure (1) dans le modèle mathématique étant complétée par la saisie de l'impédance de ligne mesurée ou de sa sélection à partir d'une liste prédéfinie ou par une valeur calculée automatiquement à partir d'une saisie de la longueur de ligne et de la section transversale.

10. Procédé pour mesurer des tensions électriques selon la revendication 9, **caractérisé en ce que** le modèle mathématique du convertisseur de tension (30) se base sur un schéma électrique équivalent du convertisseur de tension (30).

11. Procédé pour mesurer des tensions électriques selon au moins l'une des revendications 9 et 10, **caractérisé en ce que** l'influence de l'erreur du convertisseur de tension (30) raccordé est au moins partiellement compensée dans un compteur d'énergie (100).

12. Procédé pour mesurer des tensions électriques selon au moins l'une des revendications 9 à 11, **caractérisé en ce que** dans une étape du procédé, un codage (21) rapporté au type d'un convertisseur de tension (30) connecté au compteur d'énergie (100) ou à connecter à ce compteur d'énergie (100) est lu à l'aide d'un arrangement de transmission (40), **en ce que** dans une étape supplémentaire du procédé, un modèle mathématique du convertisseur de tension (30) respectif est téléchargé depuis un serveur Web (50) sur l'arrangement de transmission (40) à l'aide du codage (21) lu, **en ce que** dans une étape supplémentaire du procédé, le modèle mathématique du convertisseur de tension (30) respectif est communiqué au compteur d'énergie (100) par le biais d'une interface et **en ce que** dans une étape supplémentaire du procédé, le modèle mathématique du convertisseur de tension (30) est mémorisé dans un dispositif de mémorisation (6) du compteur d'énergie (100) .

13. Procédé pour mesurer des tensions électriques selon la revendication 12, **caractérisé en ce que** le codage (21) rapporté au type du convertisseur de tension (30) contient un lien de téléchargement servant au téléchargement du modèle mathématique ou du tableau de compensation du convertisseur de tension (20) depuis un serveur Web (50).

14. Procédé pour mesurer des tensions électriques selon au moins l'une des revendications 12 et 13, **caractérisé en ce que** dans une étape du procédé, le modèle mathématique du convertisseur de tension (30) est complété à l'aide de l'arrangement de transmission (40) de l'impédance de la ligne entre le convertisseur de tension (30) et le compteur d'énergie (100) et/ou l'impédance d'entrée de l'arrangement de mesure (1) du compteur d'énergie (100).

15. Compteur d'énergie (100) destiné à mesurer la consommation d'énergie d'au moins un récepteur raccordé à au moins un conducteur primaire, le compteur d'énergie (100) possédant au moins une entrée de mesure de courant (2) et au moins une entrée de mesure de tension (3) destinées à mesurer respectivement un courant ou une tension, le compteur d'énergie (100) possédant une unité de compensation (7) destinée à compenser l'influence de l'erreur d'un convertisseur de courant (20) raccordé à l'entrée de mesure de courant (2) sur l'au moins un signal de courant mesuré et/ou l'influence de l'erreur d'un convertisseur de tension (30) raccordé à l'entrée de mesure de tension (3) sur l'au moins un signal de tension mesuré, l'au moins un signal de courant et/ou de tension mesuré pouvant être compensé en ce qu'au moins un tableau de compensation destiné à la compensation du signal de mesure respectif en valeur et/ou en phase, basé sur le modèle mathématique du convertisseur de courant (20) ou du convertisseur de tension (30) respectif, peut être chargé ou généré à l'aide de l'unité de compensation (7) et en ce que l'au moins un tableau de compensation destiné à la compensation du signal de mesure respectif en valeur et/ou en phase peut être utilisé sur le signal de mesure respectif, **caractérisé en ce que** le modèle mathématique du convertisseur de courant (20) et/ou du convertisseur de tension (30) tient compte de la mise en charge réelle du convertisseur de courant (20) et/ou du convertisseur de tension (30) dans le sens de l'impédance d'entrée de l'arrangement de mesure (1) et de l'impédance de ligne de la ligne du convertisseur de courant (20) ou du convertisseur de tension (30) à l'arrangement de mesure (1), l'impédance de ligne entre le convertisseur de courant (20) et/ou le convertisseur de tension (30) et l'arrangement de mesure (1) dans le modèle mathématique étant complétée par la saisie de l'impédance de ligne mesurée ou de sa sélection à partir d'une liste prédéfinie ou par une valeur calculée automatiquement à partir d'une saisie de la longueur de ligne et de la section transversale.
